# EUROPEAN PATENT APPLICATION

(11) **EP 2 682 969 A1**
(43) Date of publication of application: **08.01.2014**
(21) Application number: 12174857.8
(22) Date of filing: 03.07.2012
(51) Int. Cl.: H01G 9/20

(54) **Methods of manufacturing photovoltaic electrodes**

(71) Applicant: UNIVERSITY COLLEGE DUBLIN, Dublin 4 (IE)
(72) Inventor: Dowling, Denis, Co. Dublin (IE); Dang, Binh Ha Quoc, Dublin 4 (IE)
(74) Representative: Brophy, David Timothy

(57) **Abstract**

Carbon-incorporated semiconductor photoanodes are prepared during the sintering of semiconductor coatings using a microwave plasma. The deposited carbon is concentrated on the surface of the semiconductor coatings and not in the bulk. Carbon-incorporated TiO₂ electrodes prepared using this method demonstrated a higher photovoltaic performance compared to the TiO₂ only coating, when used as photoanodes in dye-sensitized solar cell applications. Up to a 72% increase in maximum power density P_{d-max}, was observed and the short-circuit current density Jsc increased with increasing carbon content up to a maximum of 8.4% surface level carbon.

## Description

### Technical Field

This invention relates to the manufacture of photovoltaic electrodes, and in particular to the manufacture of dye-sensitized solar cells.

### Background Art

Dye-sensitized solar cells (DSSCs) exhibit a great potential as a relatively low-cost alternative to silicon-based solar cells. DSSCs were first developed by Grätzel et al. in 1991 [B. O'Regan, M. Grdtzel, Nature, 353 (1991) 737-740] and since then there has been a considerable interest in further enhancing their sunlight-to-power conversion efficiency and stability.

The main components of a DSSC electrode are 1/ a conducting substrate (usually a transparent conductive oxide-coated glass), 2/ a highly porous layer of a semiconductor material, onto which 3/ a photosensitive dye is adsorbed. It is worth mentioning that, in a fully assembled DSSC, the dye loading is performed solely on the semiconductor photoanode. The counter electrode is generally a metallic cathode with no photoelectrochemical activity. The most widely used semiconductor material in DSSCs is nanostructured titanium dioxide (TiO₂). This is due to their relatively high abundance, excellent chemical stability, well-defined optical and electrical properties, as well as low cost of processing relative to that of single and amorphous silicon-based solar cells.

TiO₂ is a wide band-gap material (3.0 to 3.2 eV depending on the crystalline phase it is in). The band gap energy of TiO₂ plays a vital role in its photoactivity performance since it dictates the region in the electromagnetic spectrum where TiO₂ is active. For TiO₂, its band gap is corresponding to its being photoactive only in the UV region, which merely makes up 5% of the solar radiation energy. A great effort has been spent on expanding the photoactivity of TiO₂ into the visible light region also by doping it with various non-metals. It is believed that the non-metal dopants introduce new mid-gap energy states in between the conduction and the balance bands of TiO₂, leading to a mixing of these energy states and resulting in a band-gap narrowing of the doped TiO₂. For DSSC applications however, it is the photosensitive dye that is responsible for absorbing sunlight and the need for doping TiO₂ with non-metals for band-gap narrowing is hence diminished. Nevertheless, recent research works suggest that embedding non-metals onto the surface, instead of into the bulk, of TiO₂ coatings still have other advantages such as increasing the charge transfer efficiency in the coatings, which in turns improves the overall DSSCs' power conversion efficiency.

Embedding non-metals onto TiO₂ nanostructures can typically be attained by:
1) treating final or growing TiO₂ nanomaterials in a solution or melt of the incorporating precursors of the non-metals
2) sputtering in an atmosphere of the incorporating precursors
3) thermal treatments in a gaseous atmosphere of the incorporating precursors

The first approach generally results in more contaminations since the precursor solution or melt commonly contains organic solvents. The second approach has the limitation of depositing very thin films (less than 1 µm) of TiO₂ which cannot be used efficiently in DSSCs.

The third approach is the most popular among the three methods due to its simplicity. It is particularly beneficial for preparing DSSC nanoparticle photoelectrodes with this approach since it incorporates the nanoparticle sintering step within. Nevertheless, the incorporation of the non-metals is attained very slowly using this method.

The present invention aims to address the shortcomings of current approaches and to provide improvements in the manufacture of photovoltaic electrodes.

### Disclosure of the Invention

There is provided a method of manufacturing a photovoltaic electrode, comprising the steps of
(a) depositing on a substrate a deposition layer comprising a dispersion having powdered semiconductor particles in a dispersion medium;
(b) creating a plasma using microwave energy excitation;
(c) introducing a gas precursor of a non-metal species into the plasma;
(c) exposing the deposition layer to said microwave-excited plasma for a sufficient period of time to introduce the non-metal species onto the deposition layer, and to sinter the semiconductor particles with said non-metal species thereby adhering said layer to the substrate; and
(d) absorbing a dye on said sintered deposition layer.

It has been found that one obtains a significantly better electrode using this method when compared to the electrodes that are traditionally sintered in a microwave plasma without the addition of a precursor of a non-metal. Improvements have been found in the electrical characteristics of the nanoparticle layer, namely a decrease in its total internal electron resistance and an increase in its electron lifetime. This in turns results in an improvement in the charge injection efficiency and hence the overall power conversion efficiency of the DSSCs.

As used herein "nanoparticle" denotes particles with a maximum diameter up to around 500nm. Typically a metal oxide DSSC will employ a number of layers with different sized particles in various layers (e.g. 400 nm in one layer, 200 nm in another layer, 20 nm in a third layer) to optimize performance. The current invention is concerned with a surface coating and thus while the characteristics of the particles closest to the surface will affect the deposition of the non-metal on the surface, the method is applicable to all such types of particle.

Without being bound by any explanation, it is hypothesized that the advantages of the invention can be attributed to a number of factors including the direct exposure of the coatings to an intense plasma that can efficiently break down the molecular precursor gases. The high-energy precursor species in the plasma are then led towards the TiO₂ coatings given the localized treatment environment within a microwave plasma system. As a result, the non-metal species are successfully introduced onto the porous nanoparticle coatings and get 'trapped' there once the particle necking starts. The non-metal dopants are then believed to act as bridges that further facilitate the charge transfer. Details of the results will be given below.

The net result is that the electrical properties of the photovoltaic electrodes prepared according to this method are significantly improved relative to the equivalent TiO₂ electrodes.

Preferably, step (a) of depositing a deposition layer comprises depositing a layer of said powdered semiconductor particles in a dispersion medium, and removing a majority of said dispersion medium to leave the particles weakly bound to the substrate in a deposition layer.

Preferably, said deposition step is selected from screen-printing, spraying, spin-coating and sol-gel deposition.

Preferably, said powdered semiconductor particles are metal oxide particles.

More preferably the powdered semiconductor particles are titanium dioxide nanoparticles or nickel oxide nanoparticles.

However, while the examples herein demonstrate the use of the technique with titanium dioxide structures, the carbon is deposited as a thin conductive layer on top of the working electrode, so as to facilitate the charge transport between the electrolyte/dye/working electrode (like an intermediate layer). The base TiO₂ structure itself is not modified, which means that any other type of semiconductor would work. In this regard the technique is qualitatively different from carbon or some other species entering the TiO₂ crystal structure, i.e. doping. When doping a semiconductor the oxide has to be selected carefully so that the resulting band gap is still tailored for DSSC applications, whereas an external layer could be applied using the current invention onto any other type of electrode and thus there is no specific reason why the application of the invention ought to be limited to titanium dioxide or nickel oxide.

Preferably, in step (c), the deposition layer is exposed to said microwave plasma for periods between 10 and 20 minutes, more preferably between 13 and 18 minutes.

Particularly advantageous results are found using N719 dye (Di-tetrabutylammonium cis-bis(isothiocyanato)bis(2,2'-bipyridyl-4,4'-dicarboxylato)ruthenium(II)). In particular, using this dye with titanium dioxide nanoparticles gives excellent results. However, any dye can be used, as can any substrate.

Preferably, said gas precursor contains carbon species. More preferably, said precursor has carbon weakly bonded to other atoms in the precursor. Most preferable, said precursor is a C1 to C4 hydrocarbon. Most preferably the hydrocarbon is methane.

Carbon-containing precursors can be broken down in the plasma to create carbon species which are deposited on top of the TiO₂ so any carbon/hydrocarbon gas such as ethane, propane, etc. is suitable. Methane is preferable because of its smaller size which assists diffusion. Other hydrocarbons will also work but maybe less effectively, i.e. the deposition rate is lower, because of the higher molecular weight (alkanes) or the strong double/triple bonds (alkenes/alkynes). C1 to C4 hydrocarbons are preferred to minimize molecular weight. Carbon dioxide could also be used but the C=O bonds are strong. Nevertheless it is within the scope of the invention to have carbon-containing precursors other than hydrocarbons, and where hydrocarbons are used, to have hydrocarbons other than methane.

There is also provided a photovoltaic electrode comprising:
(a) a substrate;
(b) a semiconductor layer comprising microwave-sintered powdered semiconductor particles;
(c) a surface layer of a non-metal species deposited upon and sintered commonly with said semiconductor layer; and
(d) a dye absorbed on said surface layer.

Preferably, said surface layer has a mean thickness of between 2 and 10 nm, preferably between 3 and 7 nm. Most preferably the layer has a mean thickness of from 4 to 6 nm

The surface layer is most preferably carbon in graphitic form.

There is also provided a dye-sensitized solar cell comprising a photovoltaic electrode as defined above and an electrolyte forming part of an electric circuit.

### Brief Description of the Drawings

The invention will now be further illustrated by the following descriptions of embodiments thereof, given by way of example only with reference to the accompanying drawings, in which:
Fig. 1 is a schematic illustration of an apparatus used to manufacture a photovoltaic electrode;
Fig. 2 shows the XRD spectra of an FTO glass slide (dotted line) and a TiO₂coated FTO that was sintered with the addition of methane (3.5 seem) during the MW argon-oxygen plasma treatment;
Fig. 3 shows the Raman spectrum in the range of 100 - 800 cm⁻¹ for the TiO₂ sintered with an addition of 3.5 sccm of precursor methane;
Fig. 4 shows the Raman spectra in the range of 900 - 2400 cm⁻¹ for the TiO₂ sintered with and without an addition of 3.5 sccm of precursor methane;
Fig. 5 shows the XPS spectrum of C1s state for the TiO₂ sintered with an addition of 3.5 sccm of precursor methane;
Fig. 6 plots carbon percentage (%C) and carbon layer thickness for the TiO₂ sintered with an addition of precursor methane at different flow rates;
Fig. 7 shows the dye adsorption level and the maximum power density (*P_{d-max}*) measured from the prepared DSSCs as a function of the precursor methane flow rate;
Fig. 8 plots the J-V responses of TiO₂ and the carbon-incorporated TiO₂ prepared using various precursor methane flow rates;
Fig. 9 shows the open-circuit voltage (*V_{oc}*) and fill factor (*FF*) measured from the prepared DSSCs as a function of the methane flow rate used in their preparation;
Fig. 10 plots the short-circuit current density (J_{sc}) measured from the prepared DSSCs as a function of the methane flow rate used in their preparation;
Fig. 11 shows the IPCE responses of TiO₂ and the best-performing 8.4% surface carbon-incorporated TiO₂ under the illumination of one sun at open-circuit voltage;
Fig. 12 shows the Nyquist plots of the EIS of TiO₂ and the best-performing 8.4% surface carbon-incorporated TiO₂; and
Fig. 13 shows the Bode plots of the EIS of TiO₂ and the best-performing 8.4% surface carbon-incorporated TiO₂.

### Detailed Description of Preferred Embodiments

### Sample preparation

Fluorine-doped tin oxide (FTO) glass slides supplied by Pilkington Glass were used as the conducting substrates. They were first ultrasonically cleaned in isopropanol for 15 minutes and then dried in an oven at 150 °C for a further 15 minutes. Other typical substrates which may be used include indium-doped tin oxide (ITO) glass and polymers, e.g. PET.

The FTO glass substrates were subsequently immersed in a solution of 40 mM titanium tetrachloride (TiCl₄) in de-ionized water for 30 minutes at 70 °C so as to deposit a thin compact layer of TiO₂ (size - 5 nm) onto FTO. The substrates were then dried in an oven for another 30 minutes.

A deposition paste was supplied by Dyesol, comprising of TiO₂ nanoparticles of size - 20 nm suspended in a dispersion medium. An absorption layer of - 3 µm (1 pass) was deposited onto the FTO glass substrates by a Digitek screen-printer using this paste. The printed glass slides were then placed in a drying box for 15 minutes.

Another deposition paste was obtained from Dyesol, comprising of TiO₂ nanoparticles of size - 400 nm suspended in a dispersion medium. A scattering layer of ∼ 6 µm (2 passes) was screen-printed on top of the absorbing layer using this paste. The printed glass slides were finally cut into small 2 x 3 cm² working electrodes that contained 1 x 1 cm² of TiO₂ prints.

The number of layers (i.e. thickness of the TiO₂ prints) is a deciding factor for the efficiency of a cell but it is immaterial for the contribution provided specifically by the current invention. Carbon can be deposited onto layers of any thickness and combination and should have the same positive effect due to the fact that it optimises the semiconductor-dye interface. Optimizing the number of layers would further enhance a cell's efficiency but is a different issue. The above-described 1 compact + 1 absorbing + 2 scattering layers is one of the most commonly used combination.

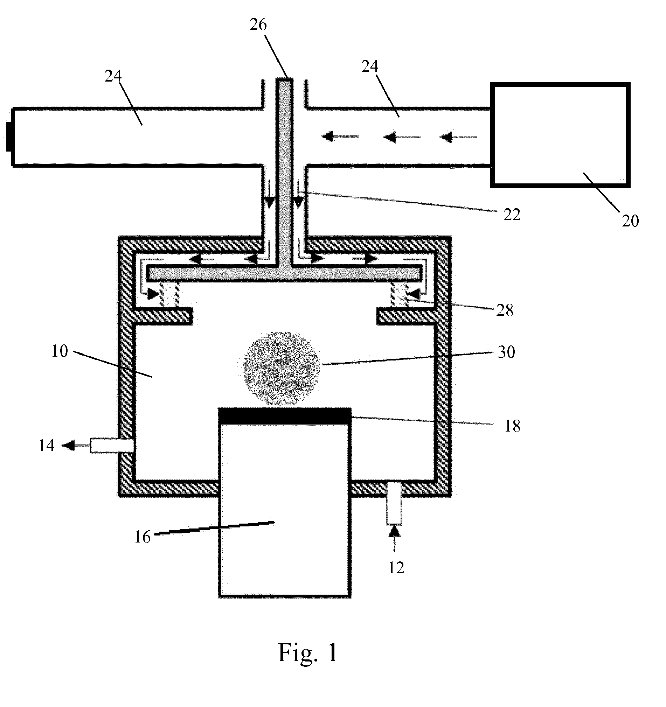

Samples prepared in this way were then subjected to microwave plasma processing as will now be described with reference to Fig. 1.

### Microwave plasma processing

Fig. 1 shows an apparatus used in the manufacture of a photovoltaic electrode, comprising a plasma chamber 10 which is pressure-controlled using a gas supply inlet 12 and a vacuum outlet 14.

A sample stage 16 is located within the chamber 10 to support one or more substrates (not shown) upon a sample holder 18 for processing. The sample stage is height-adjustable, rotatable, and is water-cooled. A Muegge microwave power supply 20 operating at 2.4 kW and 2.45 GHz provides microwave energy 22 via a tunable waveguide 24 having a tuner 26, through a quartz window 28 into the chamber 10, where it excites a plasma ball 30 located above the sample holder 18.

The chamber 10 was first pumped down to 8 Pa at which point 10 seem (standard cubic centimeters per minute) of oxygen (99.9%) and 50 seem of argon (99.998%) were introduced into the chamber. The total gas pressure was then adjusted to 800 Pa using a manual throttle valve and a microwave discharge was ignited to form a plasma ball around the samples located in the center of the chamber.

Substrate temperatures were measured using a LASCON QP003 two-colour pyrometer (not shown) from Dr. Merganthaler GmbH & Co. Input powers of 2.4 kW were provided from a Muegge microwave power supply (not shown). The samples were treated at 550°C for 15 min; these were the plasma gas conditions used for sintering TiO₂..

The incorporation of carbon into the TiO₂ was achieved by introducing a low concentration of methane (99.995%) into the argon-oxygen gas mixture during the sintering process. A methane flow rate in the range of 0.5 to 3.5 sccm was investigated and the chamber pressure was maintained at 800 Pa.

Both the TiO₂ prints sintered with and without the addition of methane were then sensitized with 0.3 mM N719 dye in a 99.8% ethanol solution for 24 hours. The DSSCs were finally assembled using the prepared TiO₂as their photoanodes and platinum-coated FTO glasses as their photocathodes with an iodide/tri-iodide-based solution as the electrolyte.

### Sample characterization

The phase composition of the samples was examined by a Siemens D500 X-ray diffractometer (XRD) operating at 40 kV and 30 mA with Cu Ka radiation at a wavelength of 0.1542 nm. The scan was in 2θ mode and spanned from 20° to 70° with steps of 0.02° per second.

X-ray photoelectron spectroscopy (XPS) analysis of the samples was carried out using a Kratos AXIS 165 spectrometer with a monochromatic A1 Kα radiation (*hv* = 1486.58 eV).

Surface morphology was visualized using an FEI Quanta 3D FEG-SEM DualBeam system.

The print thickness was obtained through step height measurements using a WYKO NT1100 optical profilometer in vertical scanning interferometry (VSI) mode.

Room temperature micro-Raman scattering spectra were obtained using a SENTERRA dispersive Raman microscope from Bruker Optics. The samples were excited with 785 nm line of a DPSS laser, focused to ∼ 1 µm by using microscope objective lens (×20).

Dye adsorption levels were obtained indirectly through UV-VIS measurements of desorbed dye molecules in 0.1 M NaOH.

Incident monochromatic photo-to-current conversion efficiency (IPCE) performance of the photoanodes was measured by illumination with monochromatic light, which was attained by a series of filters with different wavelengths. The *J-V* characteristics of the prepared DSSCs were studied under 200 lux to stimulate diffuse indoor lighting conditions.

Electron transport properties were investigated using electrochemical impedance spectroscopy (EIS) with measurements at open-circuit voltage under the illumination of one sun.

### Results and discussion

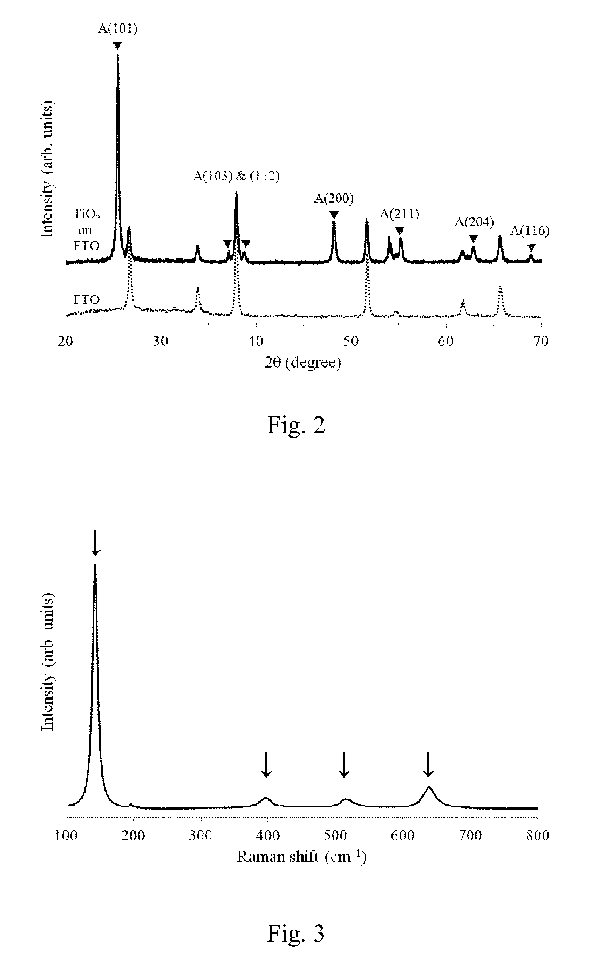

Fig. 2 shows the XRD spectra of both uncoated and a TiO₂-coated FTO glass samples, which were sintered with the addition of methane (3.5 sccm) during the MW plasma treatment process. Characteristic peaks indexed in the graph correspond to anatase TiO₂. Similar peaks were also found in the XRD spectra of the TiO₂ coatings that had been treated with and without methane at other flow rates (0.5 - 3.0 sccm). This study indicates that the addition of methane under the plasma processing conditions used did not alter the TiO₂ crystalline phase composition.

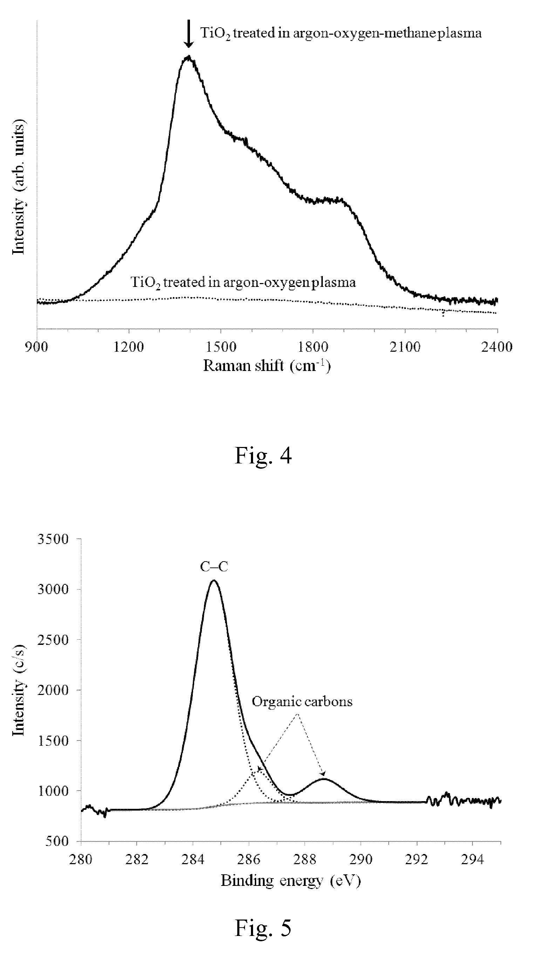

The Raman spectra of coatings such as that obtained for the sample sintered in the presence of 3.5 seem of methane (Fig. 3) also demonstrated the presence of anatase TiO₂ in the coatings, independently on whether they had been sintered with or without the addition of methane. In the case of the TiO₂ coatings sintered in the presence of methane, there is evidence for the formation of carbon as indicated by the presence of the D band around 1300 cm⁻¹ as shown in Fig. 4. It is important to note however that the corresponding G band expected for carbon structures in the range of 1580 - 1600 cm⁻¹ was extremely weak. Such a high I(D)/I(G) intensity ratio indicates that the carbon layer has only sp²-hydridized (graphite-like) bonding and no sp³-hybridized (diamond-like) character. Given that these bands were only found in the TiO₂ coatings which had been MW plasma-sintered in the presence of methane, it is reasonable to assume that methane had been dissociated in the MW plasma to carbon species which were then deposited onto TiO₂, most likely in the form of graphite.

XPS analysis was carried out to investigate the effect of methane addition at different flow rates on the sintered coatings. Fig. 5 shows a typical XPS spectrum for the C1s state with the deconvoluted peak at 284.7 eV representing C-C inorganic carbon, while the other peaks representing organic carbons. This C-C peak is absent in the case of the TiO₂ coating that had been MW plasma-sintered without the addition of methane. The coatings MW-plasma sintered in the presence of methane also had their outer layer removed by argon sputtering and the C-C peak was found to be absent in their XPS spectra as well. This indicates that the methane-deposited carbon did not diffuse significantly into the TiO₂ coating bulk.

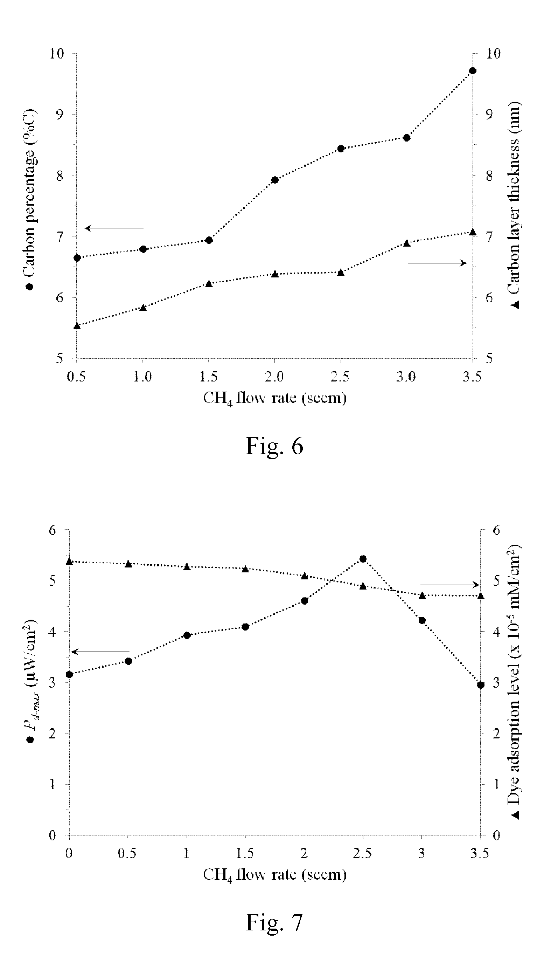

The corresponding percentage carbon (%C) of the coatings sintered in the presence of methane (0.5 - 3.5 sccm) is plotted in Fig. 6. This percent carbon figure is a measure of the percentage of carbon found in the structure using XPS, which measures approximately the top 10 nm of the structure. An equivalent measurement is the carbon layer thickness which is laid down on the surface of the semiconductor layer. While carbon layer thickness is dependent on surface characteristics of the semiconductor (e.g. particle size and porosity), and may be somewhat variable when the surface is irregular, the amount of carbon deposited can be accurately characterized and quantified by repeating the process with the same microwave parameters and gas pressures (including gas precursor flow rates) but substituting a silicon wafer to provide a regular deposition surface. The equivalent carbon layer thickness on silicon provides a repeatable measure of the more irregular thickness on an irregular surface. Thus, the optimum result of a carbon percentage of 8.4% (as measured by XPS as discussed below) can also be characterized as the amount of carbon deposited on the samples which equates to a 6.4 nm carbon layer on silicon under identical conditions. For the TiO₂ samples prepared in the examples herein that amount of carbon deposition provided optimum results for a DSSC electrode.
a regular surface, such as silicon wafer, when the process is repeated substituting a silicon wafer for the TiO₂ or other semiconductor repeated with

As shown in this figure, the amount of deposited carbon (%C) is found to increase with increasing methane flow rates in used during the MW plasma sintering process. In order to determine the thickness of the carbon layer, spectroscopic ellipsometry was used. Measurements were obtained with a Woollam M-2000 variable wavelength ellipsometer on uncoated silicon substrates which had been placed in the MW plasma adjacent to the TiO₂ coatings. The ellipsometric data were recorded at incident angles of 65°, 70°, and 75° and the measurements were fitted to a three-phase model which consists of a Si substrate, a SiO₂ interfacial layer (fixed at 2 nm), and a fittable Cauchy carbon thin film. Also shown in Fig. 6, the thickness of the carbon layer on the flat silicon wafer surface was found to increase with increasing methane flow rate and a thickness of up to 7.0 nm was obtained at a methane flow rate of 3.5 sccm for the treatment time of 15 min.

Fig. 7 displays the maximum power densities (*P_{d-max}*) of the DSSCs prepared using TiO₂ and carbon-incorporated TiO₂ photoelectrodes (6.7 - 9.7 %C prepared using 0.5 - 3.5 sccm of precursor methane accordingly). This figure demonstrates that there is an overall increase in *P_{d}-ₘₐₓ* for DSSCs using carbon-incorporated TiO₂ photoanodes as compared to the coating sintered in the absence of methane. Nonetheless, the value of *P_{d-max}* only increases with increasing carbon content, measured at the TiO₂ surface by XPS, up to 8.4% (prepared using 2.5 seem of precursor methane). Above this concentration, the maximum power density values decreased. The corresponding *P_{d}-ₘₐₓ* values for the DSSCs using TiO₂ photoanodes sintered with and without 2.5 sccm of methane addition are 3.16 and 5.44 µW/cm² respectively, representing a 72% increase in the maximum power density. Such a significant enhancement in photovoltaic performance has previously been accounted for by an increase in the level of dye adsorption on TiO₂. In this current study however, a UV-VIS analysis indicates that there was in fact a decrease in the level of dye adsorption with an increase in the methane content used during the MW plasma sintering. Based on a desorption study, the concentration of loadable dyes was found to gradually decrease from 5.38 × 10⁻⁵ to 4.71 × 10⁻⁵ mM/cm² for the photoanodes that were prepared in the absence of methane and in the presence of up to 3.5 seem of methane respectively. This decrease in dye adsorption level could be explained by an interruption of the dye loading process due to carbon layer acting as a barrier on the surface of TiO₂. For TiO₂ layers with carbon content up to the optimal 8.4% (measured at the surface by XPS), the value of *P_{d-max}* increases despite the small reduction in the level of adsorbed dyes. This would indicate that there was another factor whose impact was high enough to compensate for this decrease in the dye adsorption level.

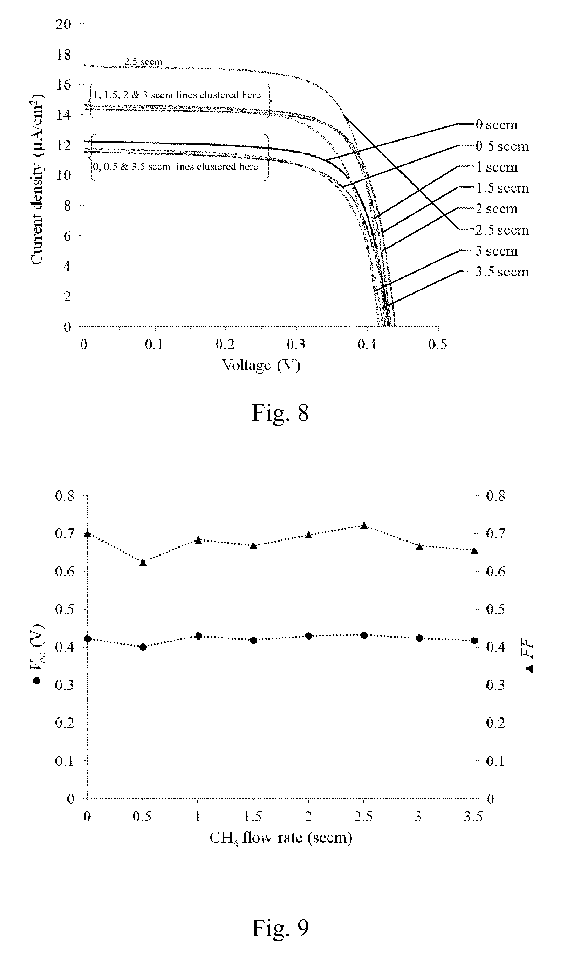

Photovoltaic measurements were carried out in order to investigate the effect of the carbon layer on the electrical properties of the coatings. Fig. 8 shows the detailed current density - voltage (*J-V*) responses of TiO₂ and the carbon-incorporated TiO₂.

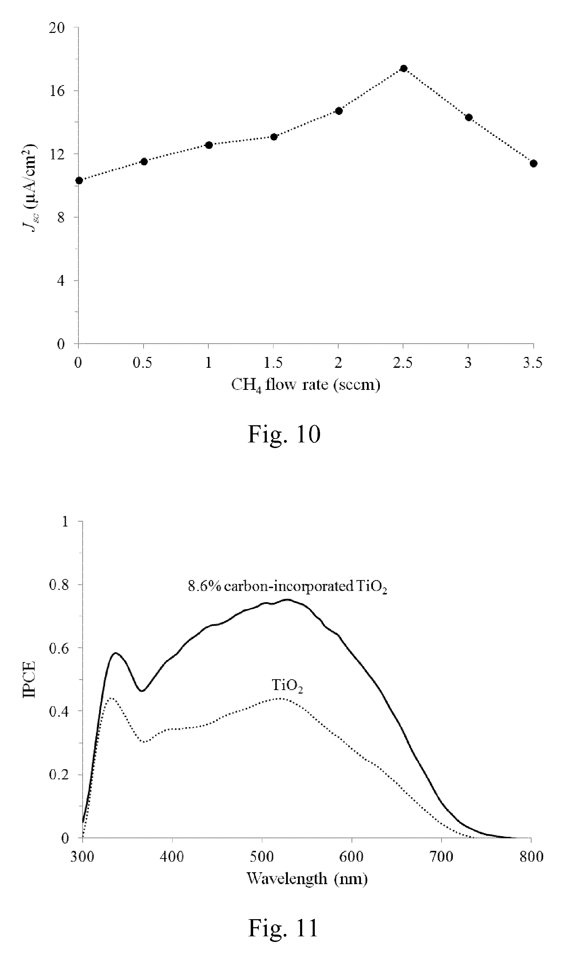

Figs. 9 and 10 show that whereas the open-circuit voltage (*V_{oc}*) and the fill factor (*FF*) remain relatively constant with varying carbon content (Fig. 9), the short-circuit current density *J_{sc}* is found to fluctuate (Fig. 10). Given that the shape of the curve in Fig. 10 is similar to that of Fig. 7 which plots *P_{d-max}* against methane flow rate (hence carbon content), it is suggested that the observed change in *P_{d-max}* values are mainly associated with change in *J_{sc}.* In other words, *J_{sc}* and hence *P_{d-max}* increase with increasing carbon content up to 8.4% when measured at the surface by XPS (layer thickness - 6.4 nm) and decrease thereafter.

The same trend is also reflected in the incident monochromatic photo-to-current conversion efficiency (IPCE) performances as seen in Fig. 11. As illustrated, the IPCE response is maximized at the wavelengths of 335 and 530 nm. Overall the IPCE responses at these two wavelengths as well as all the other wavelengths are enhanced for the carbon-incorporated TiO₂. This enhancement in IPCE is likely to be due to carbon in the form of graphite as it is a good charge carrier, which facilitates the photogenerated charge transport and suppresses the recombination and back reaction. With higher carbon contents above the 8.4% measured at the surface, the excess carbon can act as a recombination center instead of providing an electron pathway, which means short circuit can happen more easily. In this latter case, not only did carbon not offset the reduced level of dye adsorption at higher carbon content as previously discussed, but it also diminished *J_{sc}* and hence *P_{d-max}* as shown in Figs. 10 and 7 respectively.

To obtain a greater understanding of the effect of carbon incorporation, the charge transport properties of the coatings were evaluated using EIS measurements on the TiO₂ as well as the best-performing 8.4% surface carbon-incorporated TiO₂ coatings.

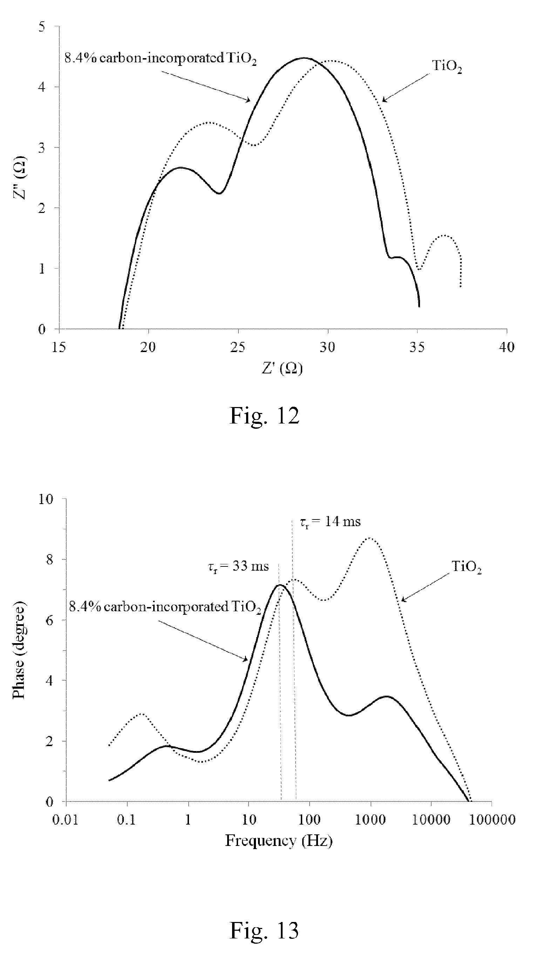

Fig.12 presents the results using Nyquist plots with the three distinctive semicircles. The first semicircle is attributed to the impedance of the charge transfer process at the counter electrode/electrolyte interface; the second semicircle is ascribed to the impedance of the charge transfer process at the working electrode/electrolyte interface; and the third semicircle is related to the Nernstian diffusion in the electrolyte.

As shown in Fig. 12, the semicircles for the 8.4% surface carbon-incorporated TiO₂ are smaller than those of the TiO₂ only photoanode. This indicates a lower interfacial charge transfer resistance and hence a higher charge transfer efficiency.

These results can also be viewed using Bode plots as shown in Fig. 13, which enables information to be extracted about the electron lifetime within the photoanodes. These plots indicated electron lifetimes of approximately 14 milliseconds for the TiO₂ and 33 milliseconds for the 8.4% surface carbon-incorporated TiO₂. This increase is again likely to be due to the deposition of carbon in the form of graphite with its high electrical conductivity acting as carriers within the cell, thus helping to facilitate the charge transport and restraining charge recombination.

In conclusion, carbon-incorporated semiconductor photoanodes were successfully prepared during the sintering of TiO₂ coatings using a MW argon-oxygen-methane plasma. Based on XPS analysis, the deposited carbon is concentrated on the surface of the TiO₂coatings and not in the bulk. The carbon-incorporated TiO₂ demonstrated a higher photovoltaic performance compared to the TiO₂ only coating, when used as photoanodes in DSSC applications. Up to a 72% increase in maximum power density *P_{d-max},* was observed for the optimized MW plasma treatment conditions, which based on ellipsometry measurements carried out with silicon wafer substrates had deposited a carbon layer thickness of 6.4 nm (8.4 %C measured by XPS surface analysis). This enhancement is likely to be due to carbon in the form of graphite with its superior electrical conductivity acting as a charge carrier. This would help to reduce interfacial charge transfer resistance, hence facilitating charge transport and suppressing recombination. As a result, the IPCE response and the short-circuit current density *Jsc* both increased with increasing carbon content up to the 8.4% surface level as highlighted above. At higher levels, the carbon could act as a recombination center as well as a barrier for dye adsorption, both of which led to a decrease in the maximum power density.

## Claims

1. A method of manufacturing a photovoltaic electrode, comprising the steps of
(a) depositing on a substrate a deposition layer comprising a dispersion having powdered semiconductor particles in a dispersion medium;
(b) creating a plasma using microwave energy excitation;
(c) introducing a gas precursor of a non-metal species into the plasma;
(c) exposing the deposition layer to said microwave-excited plasma for a sufficient period of time to introduce the non-metal species onto the deposition layer, and to sinter the semiconductor particles with said non-metal species thereby adhering said layer to the substrate; and
(d) absorbing a dye on said sintered deposition layer.

2. The method of claim 1, wherein step (a) of depositing a deposition layer comprises depositing a layer of said powdered semiconductor particles in a dispersion medium, and removing a majority of said dispersion medium to leave the particles weakly bound to the substrate in a deposition layer.

3. The method of claim 2, wherein said deposition step is selected from screen-printing, spraying, spin-coating and sol-gel deposition.

4. The method of any preceding claim, wherein said powdered semiconductor particles have a maximum particle , in a layer adjacent to the exposed surface thereof, in the size range 10 to 50 nm.

5. The method of any preceding claim, wherein said powdered semiconductor particles are metal oxide particles.

6. The method of claim 5, wherein the powdered semiconductor particles are titanium dioxide nanoparticles or nickel oxide nanoparticles.

7. The method of any preceding claim, wherein in step (c), the deposition layer is exposed to said microwave plasma for periods between 10 and 20 minutes, more preferably between 13 and 18 minutes.

8. The method of any preceding claim wherein said dye is N719 dye (Di-tetrabutylammonium cis-bis(isothiocyanato)bis(2,2'-bipyridyl-4,4'-dicarboxylato)ruthenium(II)).

9. The method of any preceding claim wherein said gas precursor contains carbon species.

10. The method of claim 9 wherein said gas precursor is a C1 to C4 hydrocarbon.

11. The method of claim 10, wherein the C1 to C4 hydrocarbon is an alkane.

12. The method of claim 12 wherein the alkane is methane.

13. A photovoltaic electrode comprising:
(a) a substrate;
(b) a semiconductor layer comprising microwave-sintered powdered semiconductor particles;
(c) a surface layer of a non-metal species deposited upon and sintered commonly with said semiconductor layer; and
(d) a dye absorbed on said surface layer.

14. A photovoltaic electrode as claimed in claim 13, wherein said non-metal species is carbon.

15. A photovoltaic electrode as claimed in claim 13 or 14, wherein said surface layer has a mean thickness of between 2 and 10 nm, preferably between 3 and 7 nm.
